(19) Europäisches Patentamt
European Patent Office
Office européen des brevets

(11) Numéro de publication: **0 539 411 B1**

# (12) FASCICULE DE BREVET EUROPEEN

(45) Date de publication de fascicule du brevet: **07.09.94**

(51) Int. Cl.5: **C08J 7/04**, C09D 151/08, G03F 7/115

(21) Numéro de dépôt: **91912469.3**

(22) Date de dépôt: **05.07.91**

(86) Numéro de dépôt internationale :
**PCT/FR91/00547**

(87) Numéro de publication internationale :
**WO 92/01734 (06.02.92 92/04)**

## (54) FILMS POLYESTERS COMPOSITES ET LEUR UTILISATION COMME COUCHE DE PROTECTION POUR PLAQUES PHOTOPOLYMERES ET PLAQUES PHOTOPOLYMERES LES COMPORTANT.

(30) Priorité: **16.07.90 FR 9009268**

(43) Date de publication de la demande:
**05.05.93 Bulletin 93/18**

(45) Mention de la délivrance du brevet:
**07.09.94 Bulletin 94/36**

(84) Etats contractants désignés:
**AT BE CH DE DK ES FR GB GR IT LI LU NL SE**

(56) Documents cités:
**EP-A- 0 235 057**
**WO-A-86/06024**
**FR-A- 2 640 983**

(73) Titulaire: **RHONE-POULENC FILMS**
**25, quai Paul Doumer**
**F-92408 Courbevoie Cédex (FR)**

(72) Inventeur: **CORSI, Philippe**
**336,rue du Doyen-Georges-Chapas**
**F-69009 Lyon (FR)**
Inventeur: **TRAVERSIER, Sylvianne**
**41, chemin du Bois-Roux**
**F-69300 Caluire (FR)**
Inventeur: **VEYRAT, Didier**
**21, rue de Nervieux**
**F-69450 S.-Cyr-au-Mont-d'Or (FR)**

(74) Mandataire: **Vignally, Noel et al**
**Rhône-Poulenc Interservices**
**Service Brevets Chimie**
**Centre de Recherches des Carrières**
**B.P. 62**
**F-69192 Saint-Fons Cédex (FR)**

EP 0 539 411 B1

Il est rappelé que: Dans un délai de neuf mois à compter de la date de publication de la mention de la délivrance du brevet européen, toute personne peut faire opposition au brevet européen délivré, auprès de l'Office européen des brevets. L'opposition doit être formée par écrit et motivée. Elle n'est réputée formée qu'après paiement de la taxe d'opposition (art. 99(1) Convention sur le brevet européen).

## Description

La présente invention a pour objet de nouveaux films polyester composites ayant des propriétés de surface particulières et leur utilisation comme couche de protection pour plaques photopolymères.

On sait que les éléments photosensibles tels que les plaques photopolymères utilisées pour préparer des plaques d'impression et en particulier des plaques d'impression flexographique sont constituées par au moins un ensemble comportant une couche d'un polymère photopolymérisable déposée entre un support et un film de protection. En général le support et le film de protection consistent en un film métallique ou en films ou feuilles de polymères thermoplastiques filmogènes. Les films polyester, et en particulier les films polyester orientés comportant une pluralité de motifs dérivés du téréphtalate d'alkylène constituent un matériau de choix pour la réalisation desdits supports ou films de protection pour éléments photosensibles. Le film de protection a pour premier rôle de protéger la couche photopolymère contre les détériorations qu'elle pourrait subir au cours des manipulations et/ou du stockage des éléments photopolymérisables ; il joue encore le rôle de séparateur lors de l'empilement des plaques photopolymérisables. Le film protecteur est séparé de la couche photopolymérisable au moment de l'utilisation des éléments photopolymérisables. Il s'est avéré avantageux lors de cette utilisation de conférer à la couche photopolymérisable une topographie de surface permettant un placage le plus complet possible de la surface de l'élément sur la plaque de verre des machines d'impression et/ou sur la surface des négatifs.

Un tel objectif ne peut être atteint rapidement que si l'air emprisonné entre la couche photopolymérisable et la plaque de verre peut s'échapper aisément lors de la mise en place de l'élément polymérisable c'est-à-dire si la couche photopolymérisable présente une rugosité suffisante. Cette rugosité peut lui être avantageusement communiquée par le film de protection par effet report si la surface de celui-ci en contact avec la couche photopolymérisable comporte une pluralité de protubérances ayant sensiblement la même hauteur et réparties de manière régulière à la surface du film protecteur en contact avec la couche photopolymérisable.

En outre pour certaines applications (fabrication de plaques offset par exemple) pour lesquelles la couche photopolymérisable est particulièrement mince (son épaisseur peut être d'environ 3 µm) il convient de veiller à ce que la surface rugueuse du film de protection soit exempte de pics provoquant la perforation de la couche photopolymérisable. La réalisation de films polyester présentant de telles propriétés de surface passe par l'utilisation de charges répondant à des exigences particulières relativement à leur dimension particulaire, à la distribution de la taille des particules, à leur aptitude à ne pas se réagglomérer lors de leur introduction dans le polyester. Généralement de telles charges sont introduites dans toute l'épaisseur du film protecteur (film dit pleine masse) ; une partie des charges ne participant pas à l'obtention du résultat recherché est alors consommée en pure perte. Par ailleurs l'utilisation d'une concentration en charge élevée dans toute l'épaisseur du film contribue à rendre ce dernier opaque, ce qui ne permet pas de voir la couche photopolymérisable à travers la couche de protection. Enfin les déchets de films pleine masse à concentration élevée en charges sont difficiles sinon impossible à recycler.

Un premier objectif de la présente invention réside dans la mise au point d'un film protecteur rugueux, de topographie régulière apte à communiquer sa rugosité à une couche photopolymérisable.

Un second objectif de la présente invention réside dans la mise au point d'un film protecteur rugueux exempt de pics susceptibles de provoquer la perforation des couches photopolymères les plus minces.

Un troisième objectif de la présente invention consiste à obtenir un film protecteur rugueux comportant une concentration élevée de charges monodisperses en limitant la quantité de charge mise en oeuvre. Un quatrième objectif de la présente invention réside dans l'obtention de films protecteurs rugueux à transparence aussi élevée que possible compte-tenu de la concentration en charge.

Plus précisément la présente invention a pour objet des films polyester composites bi-orientés constitués par une couche épaisse (A) en polyester semi-cristallin comportant sur au moins une de ses faces un revêtement (B) à base d'un polymère greffé dérivé d'un copolyester sulfoné dissipable dans l'eau et d'au moins un monomère de nature acrylique, ledit revêtement contenant des charges, caractérisés en ce que le revêtement (B), d'épaisseur inférieure à celle de la couche (A), présente les caractéristiques de rugosité de surface suivantes :

- $Rt \leqq 3$ µm
- densité de pics exprimée par le rapport $Rt/Ra \leqq 10$

et contient une charge présentant les caractéristiques suivantes :

. diamètre moyen compris dans l'intervalle de 1,5 à 2,5 µm
. monodispersité exprimée par la relative $I = D\ 75 - D\ 25 \leqq 1,2$

Par copolyesters sulfonés dissipables dans l'eau on désigne au titre de la présente invention des copolyesters solubles dans l'eau ou formant avec elle des dispersions stables et comportant une pluralité

de groupes hydroxysulfonyles ou leurs sels de métaux alcalins ou alcalino-terreux ou d'ammonium. Ces groupes ou leurs sels seront désignés par la suite par l'expression unique de "groupe hydroxysulfonyle" par raison de commodité ; ils répondent à la formule générale :

$- (SO_3)_n M$ (I)

dans laquelle :

- n est égal à 1 ou 2
- M représente un atome d'hydrogène, un cation alcalin, alcalino-terreux, ammonium ou ammonium quaternaire.

Les films polyester composites selon l'invention sont obtenus par enduction d'un film polyester (A) par une composition aqueuse contenant un polymère greffé et une quantité adéquate de particules d'une charge minérale répondant aux caractéristiques indiquées ci-avant.

Les polyesters constituant la couche (A) des films composites selon l'invention sont ceux auxquels on fait appel habituellement pour l'obtention de films semi-cristallins bi-orientés. Il s'agit de polyesters linéaires filmogènes, cristallisables par orientation et obtenus de façon usuelle à partir d'un ou plusieurs acides aromatiques dicarboxyliques ou leurs dérivés (esters d'alcools aliphatiques inférieurs, halogénures par exemple) et d'un ou plusieurs glycols aliphatiques. Comme exemple de diacides aromatiques, on peut citer les acides phtalique, téréphtalique, isophtalique, naphtalènedicarboxylique-2,5 ; naphtalènedicarboxylique-2,6. Ces acides peuvent être associés à une quantité mineure d'un ou plusieurs acides dicarboxyliques aliphatiques tels que les acides adipiques, azélaïque, hexahydrotéréphtalique. Comme exemples non limitatifs de diols aliphatiques, on peut citer l'éthylèneglycol ; le propanediol-1,3 ; le butanediol-1,4. Ces diols peuvent être associés à une quantité mineure d'un ou plusieurs diols aliphatiques plus condensés en carbone (néopentylglycol par exemple) ou cycloaliphatiques (cyclohexanediméthanol). Préférentiellement, les polyesters filmogènes cristallisables sont des polytéréphtalates ou des polynaphtalènedicarboxylates d'alkylènediols et, en particulier, le polytéréphtalate d'éthylèneglycol (PET) ou de butanediol-1,4 ou des copolyesters comportant au moins 80 % en moles de motifs téréphtalate ou naphtalènedicarboxylates d'alkylèneglycols. Avantageusement, le polyester est un polytéréphtalate d'éthylèneglycol dont la viscosité intrinsèque mesurée à 25 °C dans l'o-chlorophénol est comprise entre 0,6 et 0,75 dl/g.

Les polymères greffés utilisés pour réaliser le revêtement B des films composites selon l'invention, sont des produits connus obtenus par polymérisation radicalaire en milieu aqueux d'au moins un monomère acrylique en présence d'un polyester sulfoné dissipable dans l'eau. De tels polymères greffés et leur procédé d'obtention ont été décrits notamment dans la demande de brevet européen 0 260 203.

Les polyesters sulfonés dissipables dans l'eau, sont des produits connus, décrits notamment dans les brevets français n° 1.401.581 et 1.602.002 et la demande de brevet européen n° 0 129 674; aux fins de la présente invention, on peut avoir recours aux polyesters sulfonés décrits dans ces brevets. Plus spécifiquement, les polyesters dissipables dans l'eau sont obtenus par polycondensation d'un ou plusieurs acides aromatiques dicarboxyliques avec au moins un ou plusieurs diols aliphatiques et au moins un composé difonctionnel comportant au moins un groupe hydroxysulfonyle.

Parmi les acides aromatiques dicarboxyliques utilisables pour préparer les polyesters sulfonés dissipables dans l'eau, on peut citer, à titre d'exemples non limitatifs : les acides téréphtalique, isophtalique, phtalique, napthtalènedicarboxylique-1,4, oxydibenzoïque-4,4', la bis(hydroxycarbonyl-4 phényl)sulfone, la di-hydroxycarbonyl-4,4' benzophénone. Ces acides peuvent être utilisés seuls ou en mélanges.

Parmi les acides précités, on fait appel, de préférence, aux acides téréphtalique et isophtalique seuls ou en combinaison avec les autres acides cités. Les mélanges d'acide téréphtalique avec un ou plusieurs autres acides dicarboxyliques aromatiques et, en particulier, avec l'acide isophtalique conviennent tout particulièrement bien à l'obtention des polyesters sulfonés dissipables dans l'eau. Dans ce cas, la quantité d'acide téréphtalique exprimée en moles peut varier entre 20 et 99 % du nombre total de moles de diacides non sulfonés et de préférence entre 30 et 95 %.

Pour la préparation des copolyesters sulfonés dissipables, des acides dicarboxyliques aliphatiques comportant de 3 à 15 atomes de carbone peuvent être associés aux diacides aromatiques. Plus particulièremennt, tout ou partie de l'acide aromatique utilisé conjointement à l'acide téréphtalique (par exemple l'acide isophtalique) peut être remplacé par des acides aliphatiques tels que les acides adipique, subérique, sébacique, succinique, dodécanedioïque.

Pour la préparation des polyesters sulfonés dissipables dans l'eau, les acides dicarboxyliques peuvent être remplacés, lors de la polycondensation, par leurs dérivés utilisés habituellement dans ce type de réaction : anhydrides, esters ou chlorures d'acides. On fait appel de préférence aux esters et en particulier aux esters méthyliques.

Comme exemple de diols utilisables pour la préparation des polyesters sulfonés dissipables dans l'eau, on peut citer l'éthylèneglycol ; le butanediol-1,2 ; le diméthyl-2,2 propanediol-1,3 ; le pentanediol-1,5 ; l'hexanediol-1,6 ; le diéthylèneglycol ; le triéthylèneglycol ; le néopentylglycol ; le cyclohexanediméthanol ; le tétraéthylèneglycol ; les penta-, hexa- ou décaméthylèneglycol. L'éthylèneglycol et ses oligomères conviennent tout particulièrement bien à la préparation des polyesters sulfonés. On peut les utiliser seuls ou en mélange entre eux et/ou avec d'autres diols. Les mélanges d'éthylèneglycol et de ses oligomères de formule $HO-(CH_2-CH_2-O-)_nH$ dans laquelle n est un nombre entier compris entre 2 et 10 sont préférés.

Les groupes hydroxysulfonyles sont introduits dans le polyester par l'intermédiaire d'un composé difonctionnel, à groupe hydroxysulfonyle, susceptible de réagir avec les diacides et/ou les diols au cours de la polycondensation. Des exemples de tels monomères sont cités dans le brevet français n° 1.602.002. On fait appel, de préférence, aux sels de métaux alcalins d'acides aromatiques dicarboxyliques à groupes hydroxysulfonyles tels que ceux des acides sulfoisophtalique, sulfophtalique, hydroxysulfonyl-4, naphtalènedicarboxylique-2,7 ou à leurs dérivés et, en particulier, à leurs esters. La quantité de composé bifonctionnel à groupe hydroxysulfonyle présente dans le polyester sulfoné, exprimée en moles pour un total de 100 moles de composé difonctionnel de même nature, est de préférence comprise entre 4 moles et 30 moles %. En général, des quantités de composé difonctionnel sulfoné comprises entre 5 moles et 20 moles pour un total de 100 moles de composé difonctionnel de même nature conviennent bien. Ainsi, lorsqu'on fait appel à un sel alcalin de l'acide hydroxysulfonyl-5 isophtalique, ce composé peut représenter de 4 moles à 30 moles pour un total de 100 moles de motifs acides dicarboxyliques présents dans le polyester.

Les polyesters dissipables dans l'eau décrits précédemment sont obtenus par les procédés usuels, par exemple par réaction du ou des diols avec un mélange des esters méthyliques des différents acides nécessaires, en présence des catalyseurs usuels de transestérification, puis polycondensation des esters de diols ainsi obtenus. Les quantités de chacun des réactifs sont calculées pour que le rapport du nombre total de groupes hydroxyles alcooliques au nombre total de groupes carboxyliques soit de préférence compris entre 2 et 2,5.

Les monomères acryliques auxquels on fait appel pour la préparation des polymères greffés peuvent être représentés par la formule générale :

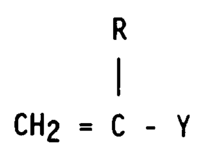

(II)

dans laquelle :

- R représente un atome d'hydrogène ou un groupe alkyle inférieur, éventuellement substitué par un groupe hydroxyle ;
- Y représente un groupe fonctionnel hydroxycarbonyle ; alkoxycarbonyle de formule $-COOR_1$ dans lequel $R_1$ est un radical alkyle comportant de 1 à 20 atomes de carbone, linéaire ou ramifié (éventuellement substitué par un reste hydroxyle); nitrile ; amide de formule $-CON(R_2,R_3)$ dans laquelle $R_2$ et $R_3$, identiques ou différents représentent un atome d'hydrogène ou un reste alkyle linéaire ou ramifié, comportait de 1 à 20 atomes de carbone.

Par radical alkyle inférieur, on désigne des radicaux alkyles comportant de 1 à 4 atomes de carbone.

Comme exemples spécifiques de radicaux $R_1$, $R_2$ et $R_3$, on peut citer les radicaux méthyle, éthyle, n-propyle, isopropyle, n-butyle, isobutyle, tertiobutyle, n-pentyle, n-hexyle, éthyl-2 hexyle, décyles, dodécyles, octadécyles. Comme exemple de radicaux hydroxyalkyles $R_1$, on peut citer les radicaux hydroxyméthyle, hydroxy-2 éthyle, hydroxy-3 propyle, hydroxy-4 butyle.

Dans la formule (II), R représente de préférence un atome d'hydrogène ou des radicaux méthyle ou hydroxyméthyle.

Parmi les dérivés acryliques de formule (I) auxquels on peut faire appel pour la préparation des polymères modifiés, on peut citer à titre non limitatif : l'acide acrylique, l'acide méthacrylique, l'acrylonitrile, le méthacrylonitrile, l'acrylamide, la méthacrylamide, la N-méthylacrylamide, les acrylates et méthacrylates de méthyle, d'éthyle, de n-propyle, d'isopropyle, de n-butyle, d'isobutyle, d'éthyl-2 hexyle, de stéaryle. Ces monomères peuvent être utilisés seuls ou en mélanges de deux ou plus de deux dérivés acryliques. Comme exemple d'association de dérivés acryliques, on peut citer les mélanges : méthacrylate de méthyle/acide acrylique et/ou méthacrylique, méthacrylate de méthyle/acide acrylique ou méthacrylique/acrylate d'éthyle ; méthacrylate de méthyle/acrylate d'éthyle/acrylamide ou méthacrylamide ; acrylamide/méthacrylamide ; acrylate de butyle/acide acrylique ; méthacrylate de butyle/acrylate d'éthyle.

Les composés acryliques peuvent encore être associés à une quantité mineure d'un ou plusieurs monomères éthylèniques tels que l'acétate de vinyle, le chlorure de vinylidène, le styrène, le méthylstyrène, les acides crotonique, itaconique, fumarique ou maléïque, les sels alcalins ou alcalino-terreux d'acides sulfoniques éthyléniques tels que les acides vinylsulfoniques, allylsulfonique, méthallylsulfonique, styrène-sulfonique. La quantité de monomère éthylènique non acrylique est calculée de façon à ce que dans le copolymère obtenu le nombre de motifs récurrents de ce monomère non acrylique exprimé en moles pour 100 moles de monomère acrylique soit de préférence inférieur ou égal à 20 % et plus préférentiellement encore à 10 %. Des quantités de motifs éthyléniques représentant de 0,1 à 5 % en moles conviennent bien.

On peut, sans sortir du cadre de la présente invention, associer à ces monomères un ou plusieurs monomères susceptibles de provoquer une réticulation de la partie acrylique. A cet effet, on peut faire appel à des monomères polyéthyléniques susceptibles de se réticuler sous l'action des générateurs de radicaux libres au cours de la polymérisaton ou bien à des monomères provoquant une réticulation de la partie acrylique par chauffage, par exemple lors du processus d'obtention du film revêtu ou lors d'un traitement thermique ultérieur du film revêtu. Comme exemple, de monomères polyéthyléniques, on peut citer le phtalate de diallyle, le divinylbenzène, les diacrylates ou diméthacrylates de diols tels que le diméthacrylate d'éthylèneglycol. Conviennent comme réticulants sous l'effet de la chaleur des hydroxyalkyl-(méth)acrylamides telles que la N-méthylolacrylamide et la N-méthylolméthacrylamide.

La quantité de monomère réticulant exprimée comme précédemment est de préférence inférieure à 5 moles pour 100 moles de monomère acrylique non réticulant. En général, elle est comprise entre 0,1 et 3 moles %.

Pour la préparation des polymères greffés on opère selon les techniques habituelles de polymérisation radicalaire des monomères à non saturation éthylénique en phase aqueuse. En général, la polymérisation est réalisée par dispersion du ou des monomères acryliques dans un volume convenable d'eau dans lequel on introduit la quantité nécessaire d'un polyester sulfoné dissipable et le cas échéant, un ou plusieurs agents émulsifiants classiques. En effet, bien que le polyester sulfoné puisse jouer lui-même le rôle d'émulsifiant permettant la dispersion du ou des monomères dans l'eau, cela n'exclut pas le recours aux agents tensio-actifs usuels tels que, par exemple, les sels alcalins de sulfates d'alcools à longue chaîne (laurylsulfate de sodium ; laurylsulfate d'éthanolamine) ; les sels alcalins d'acides sulfoniques à longues chaînes ; les émulsifiants non ioniques tels que les polyoxyéthylènesglycols et leurs dérivés ; les alkylphénols alcoxylés, éventuellement sulfatés. De préférence on opère en présence de 0,1 à 2 % en poids rapporté au total copolyester/monomères polymérisables d'un agent tensioactif. La polymérisation est initiée à l'aide des générateurs de radicaux libres habituels tels que les composés peroxydes : persulfates, eau oxygénée, peroxydes organiques (peroxydes de lauroyle, de benzoyle, hydroperoxyde de t-butyle) ; les composés azo (azodiisobutyronitrile) ; les systèmes redox associant un composé peroxydique, de préférence soluble dans l'eau et un réducteur : sels ferreux (sulfate), sulfites ou bisulfites alcalins.

D'autres adjuvants usuels de polymérisation peuvent être présents dans le milieu réactionnel. Ainsi, on peut opérer en présence d'un agent limiteur de chaîne usuel tel que les mercaptans (dodécylmercaptan, tétradécylmercaptan), de façon à régler le poids moléculaire du copolymère obtenu en fonction des propriétés désirées pour le revêtement.

La température à laquelle est conduite la polymérisation peut varier dans de larges limites. En général, une température comprise entre 10 et 100 °C et de préférence entre 20 et 80 °C convient bien.

L'étude du produit résultant de la polymérisation d'au moins un monomere acrylique tel que défini ci-avant, en présence d'un polyester dissipable, a permis de constater que le polyester est liée chimiquement au polymère acrylique.

Pour l'obtention des films composites selon l'invention, il est préférable que dans le produit résultant de la polymérisation, le polyester dissipable représente au moins 5 % en poids et de préférence au moins 10 % en poids du total polyester dissipable/(co)polymère acrylique. La présence de polyester dissipable non lié chimiquement et/ou de (co)polymère acrylique libre n'est pas préjudiciable à la mise en oeuvre du procédé ; il n'est donc pas nécessaire de les éliminer de l'émulsion obtenue. La quantité de polyester dissipable peut varier dans de larges limites. En général, cette quantité peut représenter jusqu'à 60 % en poids du total polymère dissipable/(co)polymère acrylique. Une quantité de polyester dissipable comprise entre 10 et 50 % en poids convient bien.

La concentration du polyester dissipable et du ou des monomère(s) polymérisable(s) dans la phase aqueuse de polymérisation n'est pas critique et peut varier dans de larges limites. Cette concentration est choisie en fonction du taux de matières solides désiré pour l'émulsion finale et du taux de polymérisation du ou des monomère(s) dans les conditions de polymérisation.

Le produit aqueux obtenu après polymérisation peut être utilisé directement pour l'obtention des films composites selon l'invention. Il peut également faire l'objet de traitements divers. Ainsi, on peut à la fin de la polymérisation procéder à l'élimination des monomères non transformés par les moyens usuels. Lorsque l'un ou plusieurs des composants de la réaction comporte des fonctions acides libres, ces dernières peuvent être neutralisées par addition d'une base minérale ou organique ; on fait appel de préférence à une base alcaline (soude, potasse), à un hydroxyde d'ammonium quaternaire ou à l'ammoniaque. Il peut s'agir des fonctions acide sulfonique du polyester dissipable et/ou des fonctions acide carboxylique du (co)-polymère acrylique. On peut encore ajouter à l'émulsion obtenue des adjuvants tels des stabilisants, ou des agents antistatiques. Selon une variante, on peut encore introduire dans l'émulsion obtenue des agents de réticulation externes connus des (co)polymères acryliques.

La nature des agents réticulants dépend de la nature du ou des monomères acryliques. Parmi les agents réticulants préférés, on peut citer, les résines formophénoliques, les résines amines-formol telles que les produits de condensation mélamine/formol, urée/formol, triazine/formol. La quantité de réticulant est alors en général comprise entre 0,1 et 15 % en poids et de préférence entre 0,5 et 12 % en poids par rapport au poids total du polyester dissipable et du (co)polymère acrylique présents dans l'émulsion.

Le produit résultant de la polymérisation présente diverses formes, selon la proportion et la nature des réactifs mis en jeu et/ou les conditions de la polymérisation, et/ou le traitement final appliqué au produit obtenu. Ainsi, les produits résultant de la polymérisation d'un monomère acrylique non acide avec une quantité notable d'un acide polymérisable ( acides (meth) acryliques, acide crotonique ), par exemple au moins 5 % en moles du total des monomères polymérisables peut se présenter sous forme d'une émulsion vraie lorsque les groupes acides carboxyliques sont libres ou sous forme de solutions aqueuses plus ou moins visqueuses lorsque les groupes carboxyliques sont neutralisés au moyen d'une des bases citées auparavant et en particulier au moyen d'une base alcaline. La viscosité des dispersions ou solutions de polymères modifiés n'est pas critique et peut être réglée à volonté en fonction des besoins par modification de leur teneur en extrait sec.

Pour l'obtention des films composites selon l'invention on ajoute à la composition aqueuse d'enduction des charges minérales aisément dispersable de façon homogène dans ladite composition et ne donnant pratiquement pas lieu à une agglomération de particules pendant la dispersion, le stockage ou l'utilisation des compositions d'enduction.

Afin d'obtenir une répartition régulière de pics de hauteur sensiblement identique à la surface des films selon l'invention on fait appel à des charges monodisperses c'est-à-dire à des charges caractérisées par un indice de monodispersité I = D 75 - D 25 inférieur ou égal à 1,2 et qui pourrait être égal à zéro. Les termes D 75 et D 25 seront définis ultérieurement. Le diamètre moyen D 50, défini comme le diamètre d'une particule sphérique correspondant à 50 % du poids de l'ensemble des particules lu sur la courbe de distribution cumulée reliant le pourcentage pondéral au diamètre des particules est compris entre 1,5 et 2,5 µm et de préférence entre 1,8 µm et 2,2 µm.

La nature des charges n'est pas critique pour autant qu'elles répondent aux exigences de monodispersité et de diamètre moyen indiqué ci-avant. On peut donc faire appel à des charges de nature variée : sels métalliques ($CaCO_3$ ; $BaSO_4$) ; oxydes métalliques : $SiO_2$, $TiO_2$, $ZrO_2$, $Al_2O_3$, mélanges silice/alumines, silicates. Cependant il est préférable de faire appel à des charges qui ne se réagglomèrent peu ou pas lors de leur introduction dans la dispersion aqueuse de copolymère greffé. On fait appel de préférence aux oxydes métalliques obtenus par hydrolyse d'un alcoolate métallique tels que les silicates, les titanates, les zirconates, les aluminates d'alkyle en milieu hydroalcoolique, en présence d'une base alcaline (en particulier l'ammoniaque) selon le procédé décrit par W. STOEBER et al J. Colloïd and Interface Sci 26 - (1968) 62-69 ; brevet américain 3 634 558 et dans la demande de brevet européen 0 234 945. Les oxydes métalliques obtenus de cette façon se présentent sous forme de particules sphériques monodisperses. Les oxydes sphériques monodisperses et en particulier les silices obtenues par hydrolyse alcaline en milieu hydroalcoolique des silicates d'alkyle (silicates de méthyle, d'éthyle, de n-propyle, d'isopropyle) conviennent tout particulièrement bien ; les particules de silice peuvent éventuellement avoir subit un traitement d'estérification de tout ou partie des groupes silanols présents à leur surface, selon le procédé décrit dans le brevet américain de K. ILER N° 2 801 185 et par A.K. VAN HELDEN et al., J. Colloïd Interface Sci 81 - (1981) p. 354-367, au moyen d'alcools ou de polyols tels que l'éthylèneglycol.

Par particules sphériques on désigne au sens de la présente invention des particules dont le coefficient de forme $\phi v$ est compris entre 0,45 et 0,523, $\phi v$ étant égal au rapport $V/D^3$ du volume V de la particule exprimé en $\mu m^3$ au diamètre maximum des particules.

La quantité de charge introduite dans la composition aqueuse de revêtement, exprimée en proportion pondérale par rapport au polymère greffé sec et qui conditionne la densité de pics de la couche B, dépend de la nature de la charge et en particulier de sa densité. En effet la densité de pics dépend directement du

nombre de particules de charge présentes dans le polymère. Pour un poids de charge donné et un diamètre moyen déterminé le nombre de particules est d'autant plus élevé que la densité de la charge est plus faible. D'une façon générale la quantité de charge est comprise entre 5 et 35 % en poids et de préférence entre 5 et 25 % en poids du polymère greffé sec. Dans le cas où l'on fait appel à de la silice monodisperse comme charge une quantité comprise entre 5 et 15 % en poids convient bien. La quantité adéquate de charge peut être déterminée dans chaque cas particulier au moyen d'essais simples pour communiquer à la couche (aux couches) (B) une densité de pics, exprimée par le rapport Rt/Ra, inférieure ou égale à 10 et une rugosité totale Rt ≦ 3 um.

La composition aqueuse de revêtement peut contenir des agents antistatiques, de préférence de nature anionique, pour prévenir ou limiter le dépôt de poussière sur la face rugueuse.

Les films composites selon la présente invention comportent au moins une couche B telle que définie ci-avant. Dans le cas où ils sont utilisés comme couche de protection dans des éléments photopolymérisables multicouches ils peuvent comporter une couche B sur chaque face ; le film composite ainsi constitué joue alors le rôle d'intercalaire et de feuille de protection entre les couches photopolymérisables de deux éléments. Selon une variante les films composites conformes à l'invention et ne comportant qu' une seule couche B peuvent jouer à la fois le rôle de film protecteur et le rôle de support permanent dans des éléments photopolymérisables multicouches. Dans ce cas la face portant la couche B vient en contact avec une face de la couche photopolymérisable d'un élément, et l'autre face du film composite comportant le cas échéant un revêtement adhésif de type connu est en contact avec la couche photopolymérisable d'un autre élément. On peut ainsi associer une pluralité d'éléments photopolymérisables.

Lorsque le film selon l'invention est destiné à jouer le double rôle de support et de feuille de protection la face de la couche A ne comportant pas de couche B conforme à l'invention peut être pourvue par tout moyen approprié (coextrusion, enduction en ligne, enduction en reprise) d'une couche d'un primaire d'adhérence de type connu. A cet effet on peut utiliser des polymères acryliques ou des copolyesters comportant une pluralité de groupes hydroxysulfonyles : cf. demandes de brevets européens publiées sous les N° 0 267 856 ; 0 275 801 ; 0 272 993 ; demande de brevet français 88/03302 publiée sous le N° 2 628 359 ou des polymères greffés tels que ceux décrits ci-avant. Cette face peut également être pourvue d'un revêtement antistatique de type connu déposé par tout moyen connu et notamment par enduction en ligne.

Le dépôt du revêtement (B) sur le film polyester A peut être réalisé par les différentes techniques connues de l'homme de l'art. Ainsi, l'émulsion ou la solution aqueuse de polymère greffé contenant les charges peut être déposée par gravité à partir d'une couleuse à fente, ou par passage du film dans l'émulsion ou la solution ou encore au moyen de rouleaux de transfert. L'épaisseur de la couche est contrôlée par tout moyen approprié. Le dépôt du revêtement peut avoir lieu soit avant tout étirage du film (enduction en ligne), soit après étirage avant ou après thermofixation (enduction en reprise). On préfère toutefois procéder à l'enduction du film polyester avant l'étirage ou entre deux étirages.

Préalablement à l'enduction, le film polyester peut être soumis à un traitement de surface choisi parmi ceux habituellement utilisés et, plus particulièrement, parmi les traitements physiques. Ainsi, la face destinée à recevoir le revêtement peut être soumise à des décharges électriques (traitement corona) ou à un traitement à la flamme ou à des radiations ionisantes. Cependant, de tels traitements ne sont pas indispensables.

La quantité de composition aqueuse d'enduction déposée sur le film dépend d'une part de sa teneur en extrait sec et, d'autre part, de l'épaisseur désirée pour le revêtement du film fini, c'est-à-dire après étirage et thermofixation lorsque l'enduction a lieu en ligne. Cette quantité dépend également du moment de l'enduction ; on doit évidemment tenir compte de la variation d'épaisseur du revêtement avant et après étirage, lorsque l'enduction est réalisée avant étirage.

Après enduction, le film polyester est traité à chaud pour éliminer l'eau contenue dans le revêtement et, le cas échéant, pour provoquer la réticulation du polymère. Dans le cas de l'enduction en ligne, il n'est en général pas nécessaire de procéder à un traitement thermique ; le séchage et éventuellement la réticulation sont réalisés au cours de l'étirage et de la thermofixation. On ne sortirait cependant pas du cadre de la présente invention en procédant, dans ce cas, préalablement à l'étirage et à la thermofixation, à un traitement thermique suffisant pour provoquer la coalescence du latex et le séchage.

Bien qu'il soit préférable que le film support A ne contienne pas de charge, il peut s'avérer utile, en particulier lorsque le film composite ne comporte qu'une couche (B), de lui conférer une rugosité suffisante pour en faciliter le bobinage par introduction d'une charge usuelle. Dans ce cas les charges incorporées dans la couche A ont de préférence un diamètre moyen inférieur ou égal à celui des charges de la couche A et la quantité de charge est inférieure à celle de la couche B. En général cette quantité est inférieure à 5 % en poids et se trouve comprise entre 0,1 et 3 % en poids. Cet objectif pourrait être atteint par mise en place, sur la face du film support (A) non chargé, opposée à la couche (B), d'une couche (C) contenant une

quantité adéquate d'une charge usuelle différente de celle de la couche (B), par tout moyen approprié tel que la coextrusion ou l'enduction.

Lorsque les films composites selon l'invention comportent deux couches (B) il n'est pas nécessaire que la couche (A) contienne une charge, mais on ne sortirait pas du cadre de l'invention en introduisant dans la couche (A) une charge usuelle différente de la charge monodisperse des couches (B).

Les films selon la présente invention dont la couche (A) est exempte de charge présente une turbidité inférieure à 80 %. Toutes choses égales par ailleurs un film pleine masse est totalement opaque.

Dans les films composites selon l'invention la couche (A) a en général une épaisseur allant d'environ 20 à environ 150 µm et de préférence de 30 µm à 100 µm. L'épaisseur de la (ou des) couche(s) B est généralement inférieure au diamètre moyen des particules de la charge monodisperse. De préférence cette épaisseur est comprise dans un intervalle de 0,2 à 2 µm.

Les films supports constituant la couche (A) des films composites selon l'invention sont obtenus par les procédés usuels de filmature des polyesters cristallisables. Les conditions générales de filmature sont choisies pour que le film polyester orienté semi-cristallin présente avantageusement un taux de retrait libre dans les deux directions de l'étirage (longitudinale et transversale) à 150 °C inférieur ou égal à 2 % et de préférence à 1,5 %.

Les films composites selon l'invention conviennent tout particulièrement bien comme films de protection d'éléments photopolymérisables pour la fabrication de plaques d'impression notamment par le procédé d'impression flexographique. On a constaté, en effet, qu'ils communiquent une excellente rugosité aux plaques polymères auxquelles ils sont associés et qu'ils peuvent en être aisément séparés, sans arrachage de revêtement (B) à partir du support (A) en raison de l'excellente adhérence de (B) à (A). La présence sur la couche photopolymère de fragments de revêtement (B) rendrait inutilisables les éléments photopolymères. Les films composites selon l'invention se révèlent donc particulièrement avantageux de ce point de vue. Cette utilisation constitue un second objet de la présente invention.

Un autre objet de la présente invention réside dans des éléments photopolymérisables pour plaque d'impression constitués par au moins un ensemble comprenant essentiellement un support, une couche photopolymérisable et un film protecteur, caractérisés en ce que ledit film protecteur consiste en un film polyester composite biorienté constitué par une couche épaisse (A) en polyester semi-cristallin comportant sur au moins une de ses faces un revêtement (B) à base d'un polymère greffé dérivé d'un copolyester sulfoné dissipable dans l'eau et d'au moins un monomère de nature acrylique, ledit revêtement (B) d'épaisseur inférieure à celle de la couche (A) présentant les caractéristiques de rugosité de surface suivantes :

- Rt $\leqq$ 3 µm
- . densité de pics : Rt/Ra $\leqq$ 10

et contenant une charge ayant les caractéristiques suivantes :

- . diamètre moyen : 1,5 µm à 2,5 µm
- . monodispersité : I $\leqq$ 1,2µm

Dans les éléments photopolymérisables selon la présente invention le support et la couche polymérisable sont ceux utilisés habituellement, (cf. brevets américains 2,948, 611 ; 3 024 180 ; 4 323 637 ; Research Disclosure 86/188 103). Le support permanent de la couche photopolymérisable peut être constitué par tout matériau en feuille, film ou plaque. Ainsi on peut faire appel à des films, des feuilles, des plaques métalliques (aluminium par exemple) ou à base de polymères filmogènes (polymères ou copolymères vinylique ; polyesters, polyamides, polyimides, polyesteramides). Les films, feuilles ou plaques de polyester conviennent tout spécialement bien. Le support permanent peut comporter le cas échéant une couche d'un adhésif destiné à améliorer sa liaison à la couche photopolymérisable.

Les éléments photopolymérisables conformes à la présente invention peuvent être constitués par un ou plusieurs ensembles composés essentiellement par un support permanent, une couche photopolymérisable et un film protecteur selon l'invention. Comme celà a été exposé ci-avant, dans un élément composé de deux ensemble photopolymérisables, le film protecteur comporte une couche (B) sur chaque face et joue le rôle d'intercalaire entre 2 couches photopolymérisables de deux éléments. Dans les éléments comportant plus de deux ensembles le film protecteur est constitué par la face du support de l'ensemble adjacent portant une couche (B).

Les exemples qui suivent, donnés à titre non limitatif, illustrent l'invention et montrent comment elle peut être mise en pratique. Les propriétés des charges et des films composites sont définies ci-après et leurs méthodes de mesure sont décrites.

A) Caractéristiques des films :

1° - Rugosités

a) Ecart moyen arithmétique : rugosité Ra (ou CLA)

Cette caractéristique définie dans la norme DIN 4.768 a été mesurée sur un appareil PERTHEN S6P conformément à la méthode décrite dans cette norme, dans les conditions suivantes :

| | |
|---|---|
| - valeur de la longueur d'onde de coupure (cut-off) | 0,08 mm, |
| - longueur de palpage | 1,75 mm |
| - rayon de courbure du palpeur | 4 µm |
| - force d'appui du palpeur | 0,49mN (50 mg.f) |

Le résultat retenu est la moyenne de 30 mesures effectuées sur des profils distants de 20 µm.

b) Rugosité totale Rt (hauteur pic/vallée) a été mesurée dans les mêmes conditions que Ra.

2° - Densité de pics

Elle est exprimée par le rapport Rt/Ra, mesurés comme décrit précédemment.

3° - Retrait à 150°C

Des éprouvettes circulaires de diamètre 100 mm sont découpées dans un film polyester après repérage des sens de l'étirage transversal et de l'étirage longitudinal du film. Les éprouvettes sont ensuite portées à 150°C pendant 30 mn dans une étuve ventilée thermostatée. Après refroidissement, les diamètres des éprouvettes sont déterminés dans le sens transversal (DT) et dans le sens longitudinal (DL) au moyen d'un bloc de mesure constitué par une échelle de mesure graduée par 0,1 mm gravée sur une plaque de verre éclairée et par une lunette de visée. Le retrait est exprimé et calculé au moyen des formules :

- RT = 100 - DT
- RL = 100 - DL

4° - Turbidité :

Le pourcentage de lumière dipersée transmise (ou "haze") caractérise la turbidité des films. Sa détermination est effectuée selon la norme ASTM D 100.

B - Caractéristiques des charges de la couche B

1° - Diamètre moyen des particules D 50 défini précédemment : il est mesuré à l'aide d'un granulomètre à laser de marque commerciale SYMPATEC dans une solution aqueuse de pyrophosphate de sodium.

2° - D 75 et D 25, qui représentent respectivement le diamètre d'une particule sphérique correspondant à 75 et 25 % en poids de l'ensemble des particules lu sur la courbe de distribution cumulée reliant le pourcentage pondéral de particules à leur diamètre, sont mesurés de la même façon que D 50.

EXEMPLE 1

1°) Préparation d'un copolyester sulfoné greffé :

En utilisant le procécé décrit dans l'exemple 1 de la demande de brevet européen n° 0 260 203, on a préparé un copolyester sulfoné greffé par polymérisation en milieu aqueux d'un mélange de méthacrylate de méthyle (MAM), d'acrylate d'éthyle (AE), d'acide méthacrylique (AMA), de vinylsulfonate de sodium (VS) et d'acétate de vinyle (AVM), en présence d'un copolyester sulfoné obtenu à partir de :

- 0,524 mole d'acide isophtalique,
- 0,348 mole de téréphtalate de diméthyle,
- 0,128 mole de sel de sodium de l'ester diméthylique de l'acide sulfo-5-isophtalique,

- 2,3 moles d'éthylèneglycol

et présentant un indice de viscosité de 556 mesuré à 25 °C sur une solution à 1 g de polymère dans 100 ml d'un mélange phénol/o-chloro-phénol dans un rapport pondéral 50/50 et une Tg de 29 °C à HR 65 %. Ce polyester sulfoné de poids moléculaire moyen en nombre de 17 000 a une teneur en diéthylèneglycol de 13 % en poids.

Le latex ainsi obtenu a un taux pondéral d'extrait sec de 42,9 % dont la composition pondérale est la suivante :

- MAM 34 %
- AE 25,5 %
- AMA 7,5 %
- AVM 3,5 %
- VS 0,5 %
- copolyester sulfoné 29 %

Le polymère greffé ainsi obtenu présente une température de transition vitreuse Tg(A) de 55 °C et le latex a une viscosité absolue de 0,045 Pascal.seconde.

2°) Préparation d'un film polyester composite.

Le latex de copolymère greffé décrit précédemment est dilué par addition d'eau distillée pour amener sa concentration en extrait sec à 21 % en poids puis on lui a ajouté sous agitation 8 % en poids par rapport à l'extrait sec d'une silice sphérique monodisperse vendue sous la marque commerciale MICROBEAD P400 et présentant les caractéristiques suivantes :

- D50 en µm : 1,95
- D25 en µm : 1,55
- D75 en µm : 2,41
- I en µm : 0,86

contenant 0,12 % en poids de particules de diamètre minimum 0,62 µm et 0,98 % en poids de particules de diamètre maximum 4,2 µm.

On extrude, sous forme d'un film amorphe, un polytéréphtalate d'éthylèneglycol ayant un indice de viscosité de 580 et contenant 0,06 % en poids d'une silice ayant un diamètre moyen en volume de 3,5 µm, vendue sous la marque commerciale SYLOID® 72 par la Société GRACE. Le film amorphe est refroidi à 35 °C puis étiré dans le sens longitudinal avec un taux d'étirage de 3,3 à une température comprise entre 70 et 80 °C. On dépose sur le film monoétiré 1,8 g/m$^2$ de la dispersion aqueuse décrite précédemment au moyen d'un système d'enduction de type héliogravure pourvu d'un rouleau gravé en céramique comportant 50 lignes par cm ayant une profondeur de 80 µm, (équipé d'un dispositif permettant d'éviter la décantation de la charge au sein de la composition d'enduction). Le film monoétiré enduit est ensuite soumis à un étirage transversal (taux : 3,4) à une température de 90-125 °C puis à une thermofixation à 220-230 °C. On obtient de cette façon un film enduit ayant une épaisseur de 75 µm présentant : une rugosité totale Rt égale à 2,625 µm et une rugosité Ra égale à 0,346 µm (Rt/Ra = 7,58) ; des taux de retrait à 150 °C dans le sens longitudinal et transversal égaux respectivement à 0,95 % et 0,48 % et une turbidité égale à 45 %, ce qui est notablement inférieur aux produits du commerce destinés à être utilisés comme films protecteurs pour plaques photopolymères. Le film ainsi obtenu permet, en raison de sa plus grande transparence, l'observation de la qualité du dépôt sur la ligne de fabrication.

Détermination de l'adhérence du revêtement chargé (B) au support (A)

Sur une éprouvette de film revêtu de 20 cm de longueur et de 4 cm de largeur découpée dans le sens long du film, un ruban adhésif de marque commerciale SCOTCH 396 de la MINNESOTA MINING MANUFACTURING Co, de 2,5 cm de largeur est déposé sans pression, en laissant subsister une amorce de film revêtu et une amorce de ruban adhésif de 4 cm de long. L'ensemble éprouvette/ruban adhésif est mis en place sur un marbre puis soumis à la pression d'une roulette de 4 kg le parcourant à raison de 5 allers-retours en partant du côté opposé aux amorces.

L'amorce de film est solidarisée à une mâchoire fixe d'un appareil d'arrachage du ruban adhésif et l'amorce de ce dernier à une mâchoire mobile se déplaçant à une vitesse de 1 m/s, l'angle de séparation des deux amorces étant de 180 °.

L'adhérence de la couche (B) au support (A) est appréciée par détermination de la surface de couche (B) séparée de (A). Dans le cas présent, on constate qu'il n'y a pas eu arrachage de la couche (B).

## Revendications

**1.** Films polyester composites bi-orientés constitués par une couche épaisse (A) en polyester semi-cristallin comportant sur au moins une de ses faces un revêtement (B) à base d'un polymère greffé dérivé d'un copolyester sulfoné dissipable dans l'eau et d'au moins un monomère de nature acrylique, ledit revêtement contenant des charges, caractérisés en ce que le revêtement (B), d'épaisseur inférieure à celle de la couche (A), présente les caractéristiques de rugosité de surface suivantes :
- $Rt \leqq 3\ \mu m$
- densité de pics exprimée par le rapport $Rt/Ra \leqq 10$

et contient de 5 à 35 % en poids par rapport au polymère greffé d'une charge minérale présentant les caractéristiques suivantes :
. diamètre moyen D50 compris dans l'intervalle de 1,5 à 2,5 $\mu m$
. monodispersité exprimée par la relation $I = D\ 75 - D\ 25 \leqq 1{,}2\ \mu m$.

**2.** Films polyester composites biorientés selon la revendication 1, caractérisés en ce que la charge est constituée par des particules d'oxydes métalliques sensiblement sphériques.

**3.** Films polyester composites biorientés semi-cristallins selon l'une quelconque des revendications 1 ou 2 caractérisés en ce que la couche (B) a une épaisseur inférieure au diamètre moyen des particules de la charge qu'elle contient.

**4.** Films polyester composites biorientés semi-cristallins selon l'une quelconque des revendications 1 à 3 caractérisés en ce que la charge est la silice.

**5.** Films polyester composites selon l'une quelconque des revendications 1 à 4 caractérisés en ce que le film polyester orienté support (A) est consitué par un polyester linéaire obtenu à partir d'un ou plusieurs acides aromatiques dicarboxyliques ou leurs dérivés et d'un ou plusieurs diols aliphatiques.

**6.** Films polyester composites selon la revendication 5 caractérisés en ce que le film polyester orienté support est constitué par un polymère comportant au moins 80 % en moles de motifs téréphtalate d'alkylèneglycol ou naphtalène-dicarboxylate d'alkylèneglycol.

**7.** Films polyester composites selon l'une quelconque des revendications 1 à 6 caractérisés en ce que le film polyester orienté support constituant la couche A à une épaisseur de 20 à 150 $\mu m$.

**8.** Films polyester composites selon l'une quelconque des revendications 1 à 7 caractérisés en ce que le polyester sulfoné dissipable du polymère greffé est un copolyester comportant une pluralité de motifs dérivés d'au moins deux acides dicarboxyliques dont l'un comporte au moins un groupe hydroxysulfonyle dans sa molécule et une pluralité de motifs dérivés d'au moins un diol aliphatique.

**9.** Films polyester composites selon l'une quelconque des revendications 1 à 8 caractérisés en ce que le nombre de motifs dérivés d'un acide dicarboxylique à groupe hydroxysulfonyle pour un total de 100 motifs dérivés d'acides dicarboxyliques est de 4 à 30.

**10.** Films polyester composites selon l'une quelconque des revendications 1 à 9 caractérisés en ce que le polyester dissipable est un copolyester obtenu par polycondensation d'un ou plusieurs acides aromatiques dicarboxyliques comme les acides téréphtalique, isophtalique ou phtalique avec au moins un ou plusieurs diols aliphatiques et au moins un composé difonctionnel à groupement hydroxysulfonyle tel qu'un sel de métal alcalin de l'acide hydroxysulfonyl-5 isophtalique.

**11.** Films polyester composites selon l'une quelconque des revendications 1 à 10 caractérisés en ce que le monomère de nature acrylique répond à la formule générale :

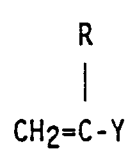

(II)

dans laquelle :

- R représente un atome d'hydrogène ou un groupe alkyle inférieur, éventuellement substitué par un groupe hydroxyle ;
- Y représente un groupe fonctionnel hydroxycarbonyle ; alkoxycarbonyle de formule $-COOR_1$ dans lequel $R_1$ est un radical alkyle comportant de 1 à 20 atomes de carbone, linéaire ou ramifié (éventuellement substitué par un reste hydroxyle); nitrile ; amide de formule $-CON(R_2,R_3)$ dans laquelle $R_2$ et $R_3$, identiques ou différents représentent un atome d'hydrogène ou un reste alkyle linéaire ou ramifié, comportant de 1 à 20 atomes de carbone.

**12.** Films polyester composites selon l'une quelconque des revendications 1 à 11 caractérisés en ce que le monomère acrylique est pris dans le groupe formé par les acrylate et méthacrylate de méthyle, les acrylate et méthacrylate d'éthyle, les acides acrylique et méthacrylique, les acrylamide et méthacrylamide.

**13.** Films polyester composites selon l'une quelconque des revendications 1 à 12 caractérisés en ce que la couche de revêtement (B) en polymère modifié a une épaisseur comprise entre 0,2 et 2 µm.

**14.** Films polyester composites selon l'une quelconque des revendications 1 à 13 caractérisés en ce que le film polyester orienté constituant la couche (A) a un taux de retrait à 150°C dans les directions longitudinales et transversales inférieur ou égal à 2 %.

**15.** Procédé d'obtention de films polyester composites selon l'une quelconque des revendications 1 à 14 caractérisé en ce que l'on procède à l'enduction d'au moins une face d'un film polyester orienté support au moyen d'une composition aqueuse de polymère greffé contenant les particules de charges minérales.

**16.** Procédé d'obtention de films composites selon la revendication 15 caractérisé en ce que le polymère modifié est mis en oeuvre sous forme d'une dispersion aqueuse.

**17.** Procédé d'obtention de films composites selon la revendication 15 caractérisé en ce que l'enduction du film polyester orienté support est réalisée avant tout étirage ou entre deux étirages du film support.

**18.** Eléments photopolymérisables pour plaque d'impression constitués par au moins un ensemble comprenant essentiellement un support, une couche photopolymérisable et un film protecteur, caractérisés en ce que ledit film protecteur consiste en un film polyester composite biorienté selon l'une quelconque des revendications 1 à 14.

**19.** Eléments photopolymérisables selon la revendication 18 comportant deux ensembles comprenant chacun essentiellement un support et une couche photopolymérisable caractérisés en ce que les deux couches photopolymérisables sont séparées par une feuille de protection constituée par un film polyester composite biorienté semi-cristallin selon l'une quelconque des revendications 1 à 14 et comportant une couche (B) sur chaque face de la couche (A).

**20.** Eléments photopolymérisables selon la revendication 18 constitués par une pluralité d'ensembles comprenant chacun un support, une couche photopolymérisable et une feuille de protection caractérisés en ce que chaque couche photopolymérisable de l'élément est séparée de la couche photopolymérisable adjacente par un film polyester composite selon l'une quelconque des revendications 1 à 14 comportant une couche (B) sur une seule des faces de la couche (A).

## Claims

**1.** Biaxially oriented composite polyester films consisting of a thick layer (A) of semicrystalline polyester comprising on at least one of its faces a coating (B) based on a graft polymer derived from a water-dispersible sulphonated copolyester and from at least one monomer of acrylic nature, the said coating containing fillers, characterized in that the coating (B), with a thickness lower than that of the layer (A), exhibits the following surface roughness characteristics:

- $Rt \leq 3$ µm

- density of peaks, expressed as the ratio Rt/Ra ≦ 10

and contains from 5 to 35 % by weight relative to the graft polymer of an inorganic filler exhibiting the following characteristics:

mean diameter D50 within the range from 1.5 to 2.5 µm

monodispersity expressed by the relationship I = D 75 - D 25 ≦ 1.2 µm.

**2.** Biaxially oriented composite polyester films according to Claim 1, characterized in that the filler consists of substantially spherical metal oxide particles.

**3.** Semicrystalline biaxially oriented composite polyester films according to either of Claims 1 and 2, characterized in that the layer (B) has a thickness lower than the mean diameter of the particles of the filler that it contains.

**4.** Semicrystalline biaxially oriented composite polyester films according to any one of Claims 1 to 3, characterized in that the filler is silica.

**5.** Composite polyester films according to any one of Claims 1 to 4, characterized in that the oriented polyester base film (A) consists of a linear polyester obtained from one or a number of dicarboxylic aromatic acids or their derivatives and from one or a number of aliphatic diols.

**6.** Composite polyester films according to Claim 5, characterized in that the oriented polyester base film consists of a polymer containing at least 80 mol% of alkylene glycol terephthalate or alkylene glycol naphthalenedicarboxylate units.

**7.** Composite polyester films according to any one of Claims 1 to 6, characterized in that the oriented polyester base film forming layer A has a thickness of 20 to 150 µm.

**8.** Composite polyester films according to any one of Claims 1 to 7, characterized in that the dispersible sulphonated polyester of the graft polymer is a copolyester containing a plurality of units derived from at least two dicarboxylic acids, one of which contains at least one hydroxysulphonyl group in its molecule, and a plurality of units derived from at least one aliphatic diol.

**9.** Composite polyester films according to any one of Claims 1 to 8, characterized in that the number of units derived from a dicarboxylic acid containing a hydroxysulphonyl group is from 4 to 30 for a total of 100 units derived from dicarboxylic acids.

**10.** Composite polyester films according to any one of Claims 1 to 9, characterized in that the dispersible polyester is a copolyester obtained by polycondensation of one or a number of dicarboxylic aromatic acids such as terephthalic, isophthalic or phthalic acids with at least one or a number of aliphatic diols and at least one difunctional compound containing a hydroxysulphonyl group, such as an alkali metal salt of 5-hydroxysulphonylisophthalic acid.

**11.** Composite polyester films according to any one of Claims 1 to 10, characterized in that the monomer of acrylic nature corresponds to the general formula:

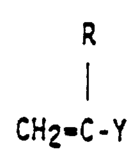

(II)

in which:

- R denotes a hydrogen atom or a lower alkyl group optionally substituted by a hydroxyl group;
- Y denotes a hydroxycarbonyl functional group, alkoxycarbonyl of formula $-COOR_1$ in which $R_1$ is a linear or branched alkyl radical containing from 1 to 20 carbon atoms (optionally substituted by a hydroxyl residue), nitrile, or amide of formula $-CON(R_2,R_3)$ in which $R_2$ and $R_3$, which are identical or different, denote a hydrogen atom or a linear or branched alkyl residue containing

from 1 to 20 carbon atoms.

**12.** Composite polyester films according to any one of Claims 1 to 11, characterized in that the acrylic monomer is taken from the group made up of methyl acrylate and methacrylate, ethyl acrylate and methacrylate, acrylic and methacrylic acids, acrylamide and methacrylamide.

**13.** Composite polyester films according to any one of Claims 1 to 12, characterized in that the coating layer (B) made of modified polymer has a thickness of between 0.2 and 2 µm.

**14.** Composite polyester films according to any one of Claims 1 to 13, characterized in that the oriented polyester film forming the layer (A) has a shrinkage ratio at 150 °C in the lengthwise and transverse directions which is lower than or equal to 2 %.

**15.** Process for obtaining composite polyester films according to any one of Claims 1 to 14, characterized in that at least one face of an oriented polyester base film is coated by means of an agueous graft polymer composition containing the particles of inorganic fillers.

**16.** Process for obtaining composite films according to Claim 15, characterized in that the modified polymer is used in the form of an agueous dispersion.

**17.** Process for obtaining composite films according to Claim 15, characterized in that the coating of the oriented polyester base film is carried out before any drawing or between two drawings of the base film.

**18.** Photopolymerizable components for a printing plate, consisting of at least one group comprising essentially a base, a photopolymerizable layer and a protective film, characterized in that the said protective film consists of a biaxially oriented composite polyester film according to any one of Claims 1 to 14.

**19.** Photopolymerizable components according to Claim 18 comprising two groups, each essentially comprising a base and a photopolymerizable layer, characterized in that the two photopolymerizable layers are separated by a protective sheet consisting of a semicrystalline biaxially oriented composite polyester film according to any one of Claims 1 to 14 and comprising a layer (B) on each face of the layer (A).

**20.** Photopolymerizable components according to Claim 18, consisting of a plurality of groups, each comprising a base, a photopolymerizable layer and a protective sheet, characterized in that each photopolymerizable layer of the component is separated from the adjacent photopolymerizable layer by a composite polyester film according to any one of Claims 1 to 14, comprising a layer (B) on only one of the faces of the layer (A).

**Patentansprüche**

**1.** Biorientierte Polyester-Verbundfilme, bestehend aus einer dicken Schicht (A) aus semikristallinem Polyester, umfassend mindestens auf einer ihrer Flächen einen Überzug (B) auf der Basis eines gepfropften Polymers, abgeleitet von einem sulfonierten, in Wasser löslichen Copolyester und mindestens ein Monomer acrylischer Beschaffenheit, wobei der genannte Überzug Einsatzstoffe (Füllstoffe) enthält, dadurch gekennzeichnet, daß der Überzug (B), dessen Dicke geringer ist als die der Schicht (A), die folgenden Rauhigkeitsmerkmale der Oberfläche aufweist:
- $Rt \leqq 3$ µm
- Dichte der Spitzen, ausgedrückt durch das Verhältnis $Rt/Ra \leqq 10$,

und 5 bis 35 Gew.-%, bezogen auf das gepfropfte Polymer, eines mineralischen Einsatzstoffes enthält, der die folgenden Merkmale aufweist:
- mittlerer Durchmesser D 50 im Intervall von 1,5 bis 2,5 um,
- Monodispersität, ausgedrückt durch die Relation $I = D\ 75 - D\ 25 \leqq 1{,}2$ µm.

**2.** Biorientierte Polyester-Verbundfilme nach Anspruch 1, dadurch gekennzeichnet, daß der Einsatzstoff aus in etwa sphärischen Teilchen von Metalloxiden besteht.

3. Semikristalline, biorientierte Polyester-Verbundfilme nach irgendeinem der Ansprüche 1 oder 2, dadurch gekennzeichnet, daß die Schicht (B) eine geringere Dicke aufweist als der mittlere Durchmesser der Teilchen ausmacht, die sie als Einsatzstoff enthält.

4. Semikristalline, biorientierte Polyester-Verbundfilme nach irgendeinem der Ansprüche 1 bis 3, dadurch gekennzeichnet, daß der Einsatzstoff Kieselerde ist.

5. Polyester-Verbundfilme nach irgendeinem der Ansprüche 1 bis 4, dadurch gekennzeichnet, daß der orientierte PolyesterfilmTräger (A) aus einem linearen Polyester besteht, erhalten ausgehend von einer oder mehreren aromatischen Dicarbonsäuren oder ihren Derivaten und einem oder mehreren aliphatischen Diolen.

6. Polyester-Verbundfilme nach Anspruch 5, dadurch gekennzeichnet, daß der orientierte Polyesterfilm-Träger aus einem Polymer besteht, umfassend mindestens 80 Mol.-% Einheiten von Alkylenglycol-terephthalat oder Alkylenglycol-naphthalin-dicarboxylat.

7. Polyester-Verbundfilme nach irgendeinem der Ansprüche 1 bis 6, dadurch gekennzeichnet, daß der orientierte Polyesterfilm-Träger, der die Schicht (A) bildet, eine Dicke von 20 bis 150 µm besitzt.

8. Polyester-Verbundfilme nach irgendeinem der Ansprüche 1 bis 7, dadurch gekennzeichnet, daß der sulfonierte, lösliche Polyester des gepfropften Polymers ein Copolyester ist, umfassend eine Vielzahl von Einheiten, die von mindestens zwei Dicarbonsäuren abgeleitet sind, von denen eine mindestens eine Hydroxysulfonyl-Gruppe in ihrem Molekül und eine Vielzahl von Einheiten umfaßt, die von mindestens einem aliphatischen Diol abgeleitet sind.

9. Polyester-Verbundfilme nach irgendeinem der Ansprüche 1 bis 8, dadurch gekennzeichnet, daß die Anzahl der von einer Dicarbonsäure mit Hydroxysulfonyl-Gruppe abgeleiteten Einheiten pro Gesamtzahl von 100 Einheiten, die von Dicarbonsäuren abgeleitet sind, 4 bis 30 betragt.

10. Polyester-Verbundfilme nach irgendeinem der Ansprüche 1 bis 9, dadurch gekennzeichnet, daß der lösliche Polyester ein Copolyester ist, erhalten durch Polykondensation von einer oder mehreren aromatischen Dicarbonsäuren, wie Terephthalsäure, Isophthalsäure oder Phthalsäure, mit mindestens einem oder mehreren aliphatischen Diolen und mindestens einer difunktionellen Verbindung mit Hydroxysulfonyl-Gruppe, wie einem Alkalimetallsalz der 5-Hydroxysulfonyl-isophthalsäure.

11. Polyester-Verbundfilme nach irgendeinem der Ansprüche 1 bis 10, dadurch gekennzeichnet, daß das Monomer mit acrylischer Beschaffenheit der allgemeinen Formel (II)

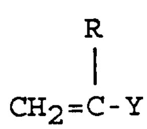

(II)

entspricht, in der

- R ein Wasserstoffatom oder eine niedere Alkylgruppe darstellt, gegebenenfalls substituiert durch eine Hydroxylgruppe,
- Y eine funktionelle Gruppe bedeutet: Hydroxycarbonyl; Alkoxycarbonyl der Formel $-COOR_1$, worin $R_1$ ein linearer oder verzweigter Alkylrest mit 1 bis 20 Kohlenstoffatomen ist (gegebenenfalls substituiert durch einen Hydrorylrest); Nitril; Amid der Formel $-CON(R_2,R_3)$, worin $R_2$ und $R_3$, gleich oder verschieden, ein Wasserstoffatom oder einen linearen oder verzweigten Alkylrest mit 1 bis 20 Kohlenstoffatomen darstellen.

12. Polyester-Verbundfilme nach irgendeinem der Ansprüche 1 bis 11, dadurch gekennzeichnet, daß das acrylische Monomer aus der Gruppe gewählt wird, die gebildet wird durch Acrylsäure-methylester und Methacrylsäure-methylester, Acrylsäure-ethylester und Methacrylsäure-ethylester, Acrylsäure und Methacrylsäure, Acrylamid und Methacrylamid.

**13.** Polyester-Verbundfilme nach irgendeinem der Ansprüche 1 bis 12, dadurch gekennzeichnet, daß die Überzugsschicht (B) ein modifiziertes Polymer mit einer Dicke zwischen 0,2 und 2 µm ist.

**14.** Polyester-Verbundfilme nach irgendeinem der Ansprüche 1 bis 13, dadurch gekennzeichnet, daß der orientierte Polyesterfilm, der-die Schicht (A) bildet, einen Schrumpfungsgrad bei 150 °C in Langsrichtung und in Querrichtung von unterhalb oder gleich 2 % besitzt.

**15.** Verfahren zur Herstellung von Polyester-Verbundfilmen nach irgendeinem der Ansprüche 1 bis 14, dadurch gekennzeichnet, daß man die Beschichtung von mindestens einer Flache eines orientierten Polyesterfilm-Trägers mit Hilfe einer wäßrigen Zusammensetzung von gepfropftem Polymer durchführt, das die Teilchen der mineralischen Einsatzstoffe enthält.

**16.** Verfahren zur Herstellung von Polyester-Verbundfilmen nach Anspruch 15, dadurch gekennzeichnet, daß das modifizierte Polymer in Form einer wäßrigen Dispersion eingesetzt wird.

**17.** Verfahren zur Herstellung von Polyester-Verbundfilmen nach Anspruch 15, dadurch gekennzeichnet, daß die Beschichtung des orientierten Polyesterfilm-Trägers ganz vor dem Streckziehen oder zwischen zwei Streckziehungen des Filmträgers realisiert wird.

**18.** Photopolymerisierbare Elemente für Druckplatten, bestehend aus mindestens einer Einheit, die im wesentlichen einen Träger, eine photopolymerisierbare Schicht und eine Schutzschicht umfaßt, dadurch gekennzeichnet, daß die genannte Schutzschicht aus einem biorientierten Polyester-Verbundfilm nach irgendeinem der Ansprüche 1 bis 14 besteht.

**19.** Photopolymerisierbare Elemente nach Anspruch 18, enthaltend zwei Einheiten, die im wesentlichen jeweils einen Träger und eine photopolymerisierbare Schicht umfassen, dadurch gekennzeichnet, daß die zwei photopolymerisierbaren Schichten durch eine Schutzfolie getrennt sind, die aus einem semikristallinen, biorientierten Polyester-Verbundfilm nach irgendeinem der Ansprüche 1 bis 14 besteht, der eine Schicht (B) an jeder Fläche der Schicht (A) umfaßt.

**20.** Photopolymerisierbare Elemente nach Anspruch 18, bestehend aus einer Vielzahl von Einheiten, die jeweils einen Träger, eine photopolymerisierbare Schicht und eine Schutzfolie umfassen, dadurch gekennzeichnet, daß jede photopolymerisierbare Schicht des Elementes von der angrenzenden photopolymerisierbaren Schicht durch einen Polyester-Verbundfilm nach irgendeinem der Ansprüche 1 bis 14 getrennt wird, der eine Schicht (B) an nur einer der Flächen der Schicht (A) umfaßt.